# EUROPEAN PATENT SPECIFICATION

(11) **EP 0 505 249 B1**
(45) Date of publication and mention of the grant of the patent: **18.10.1995**
(21) Application number: 92400682.8
(22) Date of filing: 16.03.1992
(51) Int. Cl.: C23C 16/44, C23C 16/30, C30B 25/10, C30B 25/14, C30B 25/02

(54) **Apparatus for growing mixed compound semiconductor and growth method using the same**
Vorrichtung und Verfahren zum Anwachsen eines Mischverbundhalbleiters
Appareil pour la croissance d'un composé mixte semi-conducteur et méthode de croissance utilisant un tel appareil

(30) Priority: 18.03.1991 JP 52339/91
(43) Date of publication of application: 23.09.1992
(73) Proprietor: FUJITSU LIMITED, Kawasaki-shi, Kanagawa 211 (JP)
(72) Inventor: Saito, Tetsuo, c/o Fujitsu Limited, Kawasaki-shi, Kanagawa 211 (JP); Nishino, Hironori, c/o Fujitsu Limited, Kawasaki-shi, Kanagawa 211 (JP); Murakami, Satoshi, c/o Fujitsu Limited, Kawasaki-shi, Kanagawa 211 (JP); Sakachi, Yoichiro, c/o Fujitsu Limited, Kawasaki-shi, Kanagawa 211 (JP)
(74) Representative: Joly, Jean-Jacques

(56) References cited:
- EP-A- 0 322 050
- GB-A- 2 156 857
- US-A- 4 904 337

## Description

### BACKGROUND OF THE INVENTION

### 1. Field of the Invention

This invention relates to an apparatus for growing a mixed compound semiconductor comprising at least three elements by vapor phase epitaxy, and more particularly to an apparatus for growing a mixed compound semiconductor having a uniform mixing ratio and a growth method using the same.

A mixed compound semiconductor comprises at least two binary compound semiconductors, and the energies for forming each binary compound semiconductor is different from each other. When a plurality of source gases, each comprising element gas are mixed and introduced into a reaction chamber, a grown mixed compound semiconductor layer on a substrate has non-uniform mixing ratios (x-values) depending on a position of the substrate surface. The present invention relates to an apparatus which is used for growing the compound semiconductor layer having uniform x-values throughout the entire grown semiconductor layer on the substrate surface.

### 2. Description of the Related Art

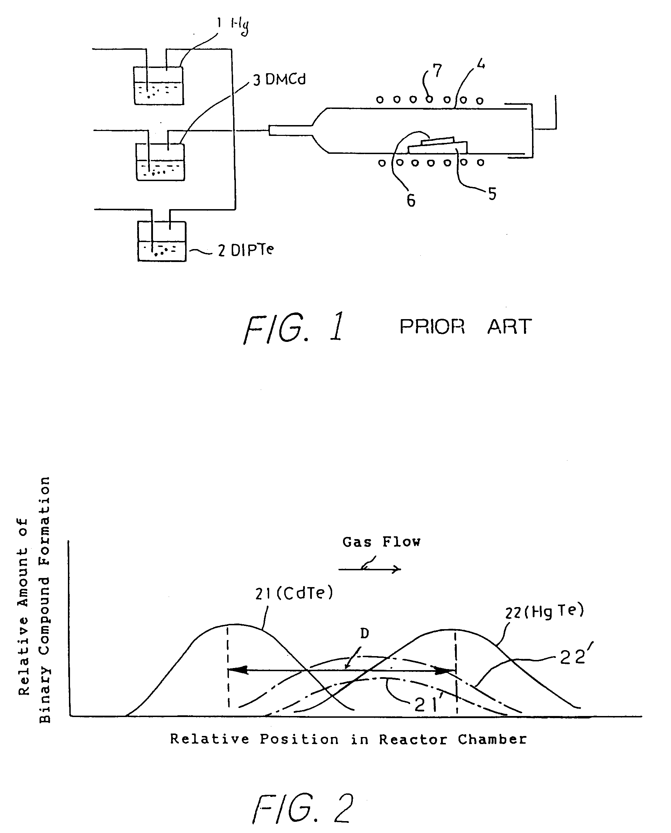

A general method of growing a mixed compound semiconductor of the prior art utilizes an apparatus schematically shown in Figure 1. An exemplary ternary semiconductor Hg₁₋ₓCdₓTe of a group II-VI compound semiconductor is taken up for explaining the prior art method using the apparatus of Figure 1. The mixed compound semiconductor Hg₁₋ₓCdₓTe has a characteristic of a small energy bandgap and is known as a detector material for infrared rays. The mixing ratio x included in the above expression Hg₁₋ₓCdₓTe is defined as a ratio of binary compound semiconductor CdTe to ternary compound semiconductor HgCdTe and plays an important role to determine the most sensitive wavelength of infrared rays in detection.

A mercury (Hg) bubbler 1 supplies mercury vapor contained in a bubbling hydrogen gas. A diisopropyltellurium (abbreviated hereinafter as DIP-Te) bubbler 2 supplies DIP-Te vapor contained in a bubbling hydrogen gas. A dimethylcadmium (abbreviated hereinafter as DM-Cd) bubbler 3 supplies DM-Cd vapor contained in a bubbling hydrogen gas. The above three source gases are introduced into a reactor chamber 4 in which a substrate stage 5 is arranged. A substrate 6 of such as gallium arsenide (GaAs) is disposed on the stage 5 which is heated during the growth by a RF coil 7 arranged outside the reactor chamber 4. DIP-Te and DM-Cd source gases are decomposed into element gases, and Te, Cd and Hg molecules react with each other forming binary semiconductors CdTe and HgTe around the heated substrate and deposit on the substrate 6 forming an epitaxial Hg₁₋ₓCdₓTe layer. The method falls under the category called MOCVD (Metal Organic Chemical Vapor Deposition).

The above method includes problem that binary compound semiconductor CdTe is first formed on the upstream side of the mixed source gas flow in the reactor chamber 4 and binary compound semiconductor HgTe is later formed on the downstream side, since necessary energy of forming CdTe is smaller than that of HgTe. Therefore, the x-value of the grown ternary compound semiconductor Hg₁₋ₓCdₓTe is not uniform on the substrate surface. This is exaggeratedly and schematically shown by solid curves 21, 22 in Figure 2. The abscissa shows an arbitrary relative distance from an input end of the reactor chamber 4 and the ordinate shows a relative quantity of formed binary semiconductors. Curve 21 denotes that the binary semiconductor CdTe alone is first formed on the upstream side of the reactor chamber and curve 22 denotes that the binary semiconductor HgTe is formed on the downstream side thereof. As the result, the grown ternary semiconductor Hg₁₋ₓCdₓTe on the substrate has a composition such that the x-value thereof gradually decreases from 1 (upstream side) to 0 (downstream side) in an extreme case. The larger the distance D between peak positions of these two curves is, the more the change in x-value on the surface of the grown ternary compound layer Hg₁₋ₓCdₓTe exists.

As explained above, when at least three source gases are mixed and thereafter introduced into a reaction chamber for growing a mixed compound semiconductor, a binary compound semiconductor having a smaller formation energy is formed on the upstream side of the reaction chamber, and a binary compound semiconductor having a larger formation energy is formed on the downstream side thereof.

In order to improve uniformity of the grown semiconductor, Japanese Unexamined Patent Publication SHO 63-318733 discloses an MOCVD apparatus of a vertical reactor type, in which a preliminary heating plate having a plurality of throughholes which is heated during the growth is disposed on the upstream side of the reactor. Japanese Unexamined Patent Publication HEI 1-201926 discloses an MOCVD apparatus of a horizontal reactor type, in which a heating means is provided in the reactor. However, according to the above two references, since source gases are heated almost uniformly, the difference in formation energies can not been solved basically.

### SUMMARY OF THE INVENTION

It is a general object of the invention to provide an apparatus for growing a mixed compound semiconductor layer on a substrate having a more uniform mixing ratio.

It is another object of the invention to provide a method of growing a mixed compound semiconductor layer having a uniform mixing ratio, which can be precisely controlled.

It is still another object of the invention to provide an apparatus for growing a group II-VI ternary compound semiconductor Hg₁₋ₓCdₓTe layer having an almost constant x-value over an entire substrate surface.

It is a further object of the invention to provide an apparatus for growing a mixed compound semiconductor comprising elements more than three such as a quaternary semiconductor and provide a growth method using the apparatus.

According to the present invention, these and other objects are achieved by utilizing an apparatus for growing a mixed compound semiconductor layer which comprises: a reactor chamber of a horizontal type, the reactor chamber comprising a partition plate separating the upstream region of the reactor chamber into an upper region and a lower region, the upper and lower regions being joined together at a region forming a growth region on the down stream side of the reactor chamber; a first and a second inlet port provided at the upstream end of the lower region for admitting first and second source gases respectively, a third inlet port provided at the upstream end of the upper region for admitting a third source gas, and an outlet port provided at the downstream end of the growth region for exhaust; a substrate stage for disposing a substrate on which the compound semiconductor layer is being grown, thereby the substrate surface being exposed to the growth region and forming a smooth surface for allowing a laminar gas flow; and heating means arranged outside the reactor chamber.

The basic concept of the present invention exists in that the source gas having a smaller formation energy is separated by the partition plate and later mixed with other source gases near the growth region, and a preliminary heating unit can enhance reaction of the source gas having a larger formation energy, resulting in forming a mixed compound semiconductor having a uniform mixing ratio. This concept can be applied not only for growing a ternary compound semiconductor but also for growing a quaternary compound semiconductor.

Other aspects, objects, and the several advantages of the invention will become apparent to one skilled in the art from the reading of the following disclosure with reference to the drawings.

### BRIEF DESCRIPTION OF THE DRAWINGS

Figure 1 shows a schematic cross sectional view of a reactor chamber of the prior art and a source gas system for growing a ternary compound semiconductor;
Figure 2 is a graph showing a relative growth amount versus axial position in a reactor chamber, each curve corresponding to each of two binary compound semiconductors constituting a mixed ternary semiconductor, in which solid curves show the data using the prior art apparatus and broken curves show the data using an embodied apparatus of the invention;
Figure 3 shows a basic cross sectional view of an apparatus in accordance with the present invention for easy understanding of the principle of the invention;
Figure 4 shows a schematic cross sectional view of an actual embodied apparatus for growing a ternary compound semiconductor layer;
Figure 5 shows a side view of an improved inlet arrangement of source gases into a reactor chamber by the invention;
Figure 6 illustrates schematically a top view of source gas flow when the above structure of Figure 5 is applied;
Figure 7 shows a cross sectional view of a mercury bubbler of the invention;
Figure 8 shows the x-value data obtained according to the present invention, and the prior art data is also shown for comparison; and
Figure 9 shows a schematic cross sectional view of an apparatus for growing a quaternary compound semiconductor in accordance with the present invention.

Same or like reference numerals designate same or similar parts throughout the drawings.

### DETAILED DESCRIPTION OF THE PREFERRED EMBODIMENTS

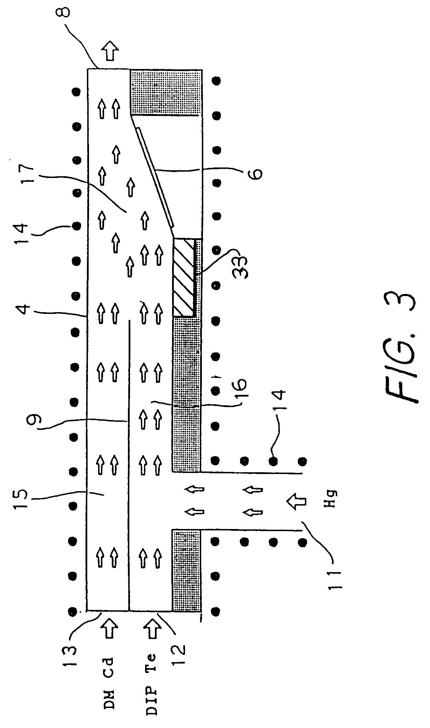

The concept of the present invention is first explained using Figure 3. Figure 3 shows a schematic cross sectional view of a basic structure of an embodiment for growing a mixed ternary compound semiconductor Hg₁₋ₓCdₓTe. A reactor chamber 4 has three separate inlet ports 11, 12, 13 for three source gases and one outlet port 8 for exhaust. A carrier gas of hydrogen and mercury vapor are mixed forming a first source gas (Hg) and supplied to the inlet port 11, and a hydrogen carrier gas and DIP-Te gas are mixed forming a second source gas (DIP-Te) and supplied to the inlet port 12, and a hydrogen carrier gas and DM-Cd gas are mixed forming a third source gas (DM-Cd) and supplied to the inlet port 13. A substrate 6 is disposed on the downstream side of the reactor 4, the surface thereof having a small inclination toward the gas flow.

A specific feature of the apparatus is that a partition plate 9 is provided in the reactor chamber 4, the partition plate 9 extending from the upstream end of the reactor chamber to the middle portion thereof, i.e., a small distance before the substrate position. Therefore, the reactor chamber 4 is divided into an upper region 15 and a lower region 16 on the upstream side and a growth region 17 on the downstream side. The partition plate 9 has the function of separating the third source gas (DM-Cd) from the first and second source gases (Hg and DIP-Te respectively). The reactor chamber 4 further provides a heater 14 encircling the chamber 4, which is heated at a predetermined temperature during the growth in order to prevent mercury vapor from condensing.

Next, a method of growing a Hg₁₋ₓCdₓTe layer on a gallium arsenide (GaAs) substrate is described. First, hydrogen gas only is introduced into the reactor chamber 4 and the GaAs substrate 6 is heated by an RF coil (not shown) at a temperature of about 600°C for 30 minutes, during which the substrate surface is cleaned removing natural oxides on the substrate surface. Next, the second source gas (DIP-Te) and the third source gas (DM-Cd) are introduced into the reactor chamber 4 with a flow rate of about 3 to 6 l/min and a gas pressure of 25,33 kPa (0.25 atm), and the GaAs substrate 6 is heated at about 400°C, resulting in forming a CdTe buffer layer on the substrate.

Next, the reactor chamber 4 is heated by the heater 14 at a temperature of about 250°C. All first through third source gases are introduced into the reactor chamber, whereby each partial pressure in the source gas is controlled at 1,01 kPa (1 × 10⁻² atm) for the Hg gas, 50,65 Pa (5 × 10⁻⁴ atm) for the DIP-Te gas, and 5,07 Pa (5 × 10⁻⁵ atm) for the DM-Cd gas. The total gas pressure of the mixed source gas is controlled at the atmospheric pressure and the total flow rate is controlled at about 8 l/min. The substrate 6 is heated by the RF coil at about 350°C to 400°C.

It is easily understood that formation of CdTe does not occur in the upper region 15 but formation of HgTe does first occur in the lower region 16 before source gases flow into the growth region 17. On the substrate surface, decomposed cadmium molecules react with tellurium molecules and deposit on the substrate 6 forming a Hg₁₋ₓCdₓTe layer thereon.

It is further found that a preliminary heating unit 33 which is arranged near the substrate 6 and on the upstream side of the substrate will accelerate reaction between the first and second gases, i.e., Hg and DIP-Te. The reason therefor is that these two gases have a larger formation energy in forming a binary semiconductor HgTe layer than that between DM-Cd and DIP-Te.

The effect of the above partition plate 9 and the preliminary heating unit 33 is illustrated in Figure 2. A broken curve 21' which shows formation of CdTe moves toward the right side and a broken curve 22' which shows formation of HgTe moves toward the left side. The distance between peak positions of two curves becomes very small. When each source gas flow is precisely controlled, flatter curves can be obtained when faster gas flow is used, and a deposition ratio of CdTe to HgTe on the substrate 6 is almost constant in the growth region 17, which means the grown Hg₁₋ₓCdₓTe layer has a constant x-value.

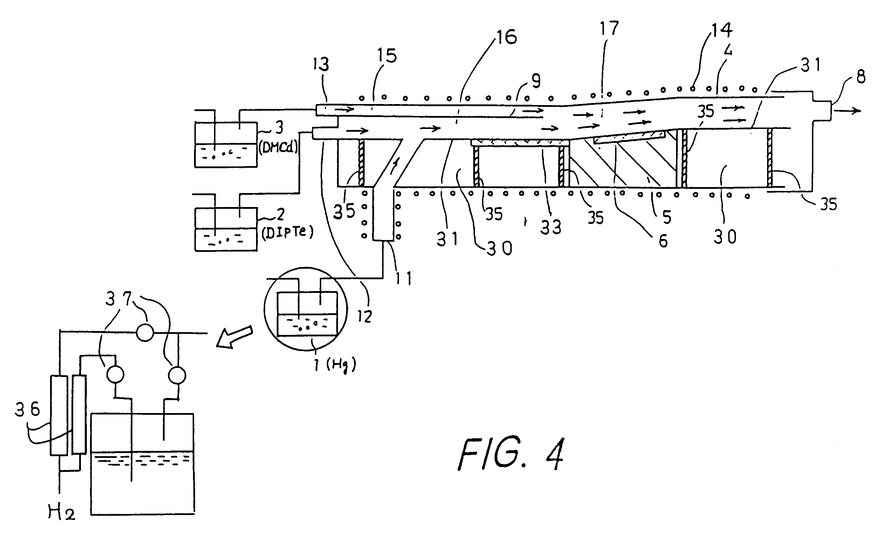

The MOCVD apparatus shown in Figure 3 shows only a basic structure. The detailed structure of the embodied apparatus is shown in Figure 4. Same reference numerals used therein designate same or similar parts. A reactor chamber 4 provides a supplementary region 30 which is separated by an auxiliary partition plate 31. The supplementary region 30 does not contribute to the flow of source gases, but furnishes space for arranging such as a substrate stage 5, a preliminary heating unit 33, and support members 35. The preliminary heating unit 33 has dimensions such as 80mm × 80mm × 5mm and is made of graphite. The auxiliary partition plate 31 has openings for exposing a substrate 6 on the substrate stage 5 and the preliminary heating unit 33, and has a function of making source gases flow laminar in upper and lower regions 15, 16 and growth region 17. The plural support members 35 support the auxiliary partition plate 31 and the preliminary heating unit 33.

The surface of the preliminary heating unit 33 is exposed to the lower region 16, and located near the substrate 6 and on the upstream side of the substrate. The preliminary heating unit 33 is heated by any means of an RF coil arranged outside the reaction chamber 4, a heater attached to the preliminary heating unit 33, etc. (these are not shown in Figure 4) to about 300°C during the growth of the Hg₁₋ₓCdₓTe layer. The preliminary heating unit 33 has a function of accelerating reaction of formation of HgTe. Each of bubblers 1, 2 and 3 comprises a mass flow controller 36 and plural valves 37 for controlling a flow rate of source gas, which are shown in an enlarged view for the bubbler 1 in Figure 4. A heater 14 encircling the reactor chamber 4 has a function of heating the chamber wall at about 250°C to prevent mercury vapor from condensing on the inside wall of the reactor chamber 4.

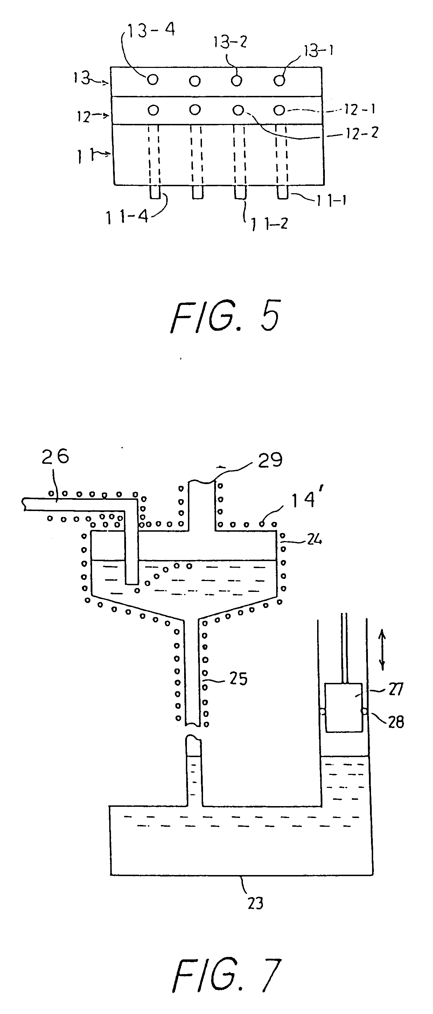

As the inlet ports 11, 12, and 13 of the embodiment hitherto explained, only a single inlet gas nozzle is illustrated for each of them. However, it is preferable to provide a plurality of nozzles for each source gas. Figure 5 shows a side view on the upstream side of the reactor chamber 4, in which each source gas line is branched to four inlet nozzles, 11-1 to 11-4, 12-1 to 12-4, and 13-1 to 13-4. Four inlet nozzles 11-1 to 11-4 are connected to the bubbler 1 of Hg, and four inlet nozzles 12-1 to 12-4 are connected to the bubbler 2 of DIP-Te, and four inlet nozzles 13-1 to 13-4 are connected to the bubbler 3 of DM-Cd. By controlling gas flow through each nozzle, uniform laminar gas flows in the upper and lower regions 15, 16 can be obtained. This is schematically illustrated by a top view of gas flow in Figure 6, in which reference numerals nozzle-1 to nozzle-4 correspond to respective four nozzles for each source gas. The upper and lower regions further partitioned by additional three vertical partitions 40, 41 and 42 contribute to increase uniformity of gas flow. By controlling each gas flow of all inlet nozzles, an extremely uniform Hg₁₋ₓCdₓTe layer can be obtained.

The method of growing a Hg₁₋ₓCdₓTe layer on a GaAs substrate 6 is almost similar to the method previously applied using the apparatus of Figure 3. At first, the substrate 6 is cleaned by heat treating in the hydrogen gas. Secondly, a CdTe buffer layer having a thickness of 4 µm is grown flowing the second and third source gases. Finally, the Hg₁₋ₓCdₓTe layer having a thickness of 10µm is grown on the CdTe buffer layer flowing all three source gases into the reactor chamber 4.

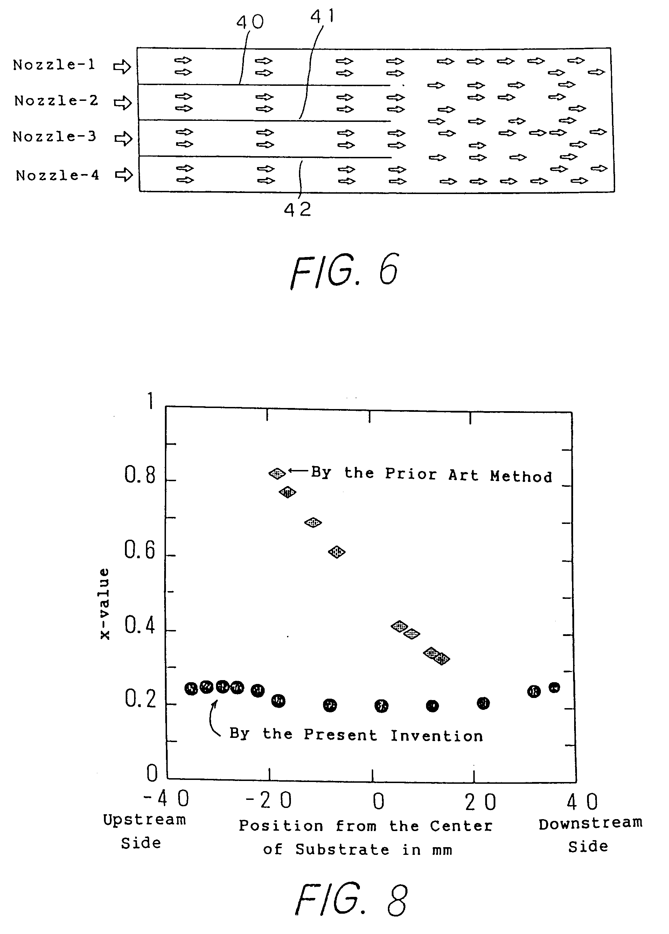

After growing the Hg₁₋ₓCdₓTe layer having a thickness of 10µm on the substrate of 7.62cm (three inches) in diameter, x-values are tested changing the position on the substrate surface. The test data are shown in Figure 8, in which the abscissa shows positions from the center of the substrate and the ordinate shows the x-values. The data shows that a peak-to-peak deviation in x-values is about. 0.05 for the projected x-value of 0.21. In Figure 8, the prior data utilizing the prior art apparatus of Figure 1 is also shown for a comparison purpose. There is a tremendous improvement in x-value uniformity.

The apparatus thus far described using Figures 3 and 4 is used for growing a ternary mixed compound semiconductor; however, the present invention can be applied for growing a mixed compound semiconductor comprising four elements and more.

In growing a quaternary compound semiconductor of such as Hg_{1-x-z}CdₓZn_{z}Te, four source gases are utilized, namely, Hg, DIP-Te, DM-Cd source gases as previously described and a diethylzinc (DE-Zn) source gas. Formation energies of HgTe, ZnTe and CdTe decrease in this order as shown in the following inequality relation,

HgTe > ZnTe > CdTe.

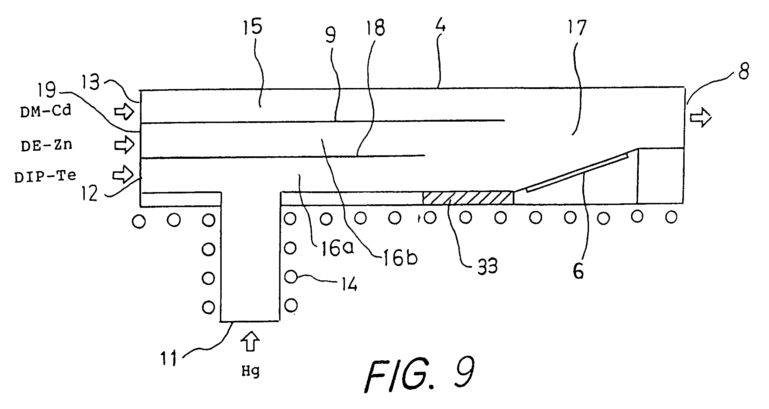

An apparatus for growing the quaternary compound semiconductor Hg_{1-x-z}CdₓZn_{z}Te is shown in Figure 9, in which a second partition plate 18 and a fourth inlet port 19 are provided. The second partition plate 18 divides a lower region 16 into two regions 16a and 16b. The horizontal length of the second partition plate 18 is shorter than that of a partition plate 9. First and second inlet ports 11 and 12 are used for introducing Hg and DIP-Te source gases respectively, and a third inlet port 13 is used for introducing DM-Cd source gas, and the fourth inlet port 19 is used for introducing the DE-Zn source gas. A partial pressure of DE-Zn gas is about 3,04 Pa (3 × 10⁻⁵ atm) and other conditions for the growth are almost the same as applied in the case of growing the ternary compound semiconductor Hg₁₋ₓCdₓTe. The apparatus structure of Figure 9 shows that two source gases of Hg and DIP-Te which constitute the largest formation energy when subjected to mutual reaction, are first mixed and heated, and thereafter the source gas having the next largest formation energy is mixed, and finally the source gas having the smallest formation energy is mixed. A quaternary semiconductor Hg_{0.7}Cd_{0.2}Zn_{0.1}Te having a uniform x-value and a uniform z-value can be obtained.

In Figure 9, a heater 14 is provided only for a lower half of the reaction chamber 4, because an object of the heater 14 is to prevent mercury from condensing on the inside wall of the chamber 4 and it is preferable not to heat the upper region 15 where the DM-Cd source gas is flowing.

A convenient mercury bubbler 1 of the invention is shown in Figure 7. This type of bubbler 1 is facilitates the control of mercury vapor flow, and comprises a main bubbler unit 24, a mercury reservoir 23, a connection pipe 25 connecting therebetween, and a piston pump 27 which controls a liquid mercury level in the main bubbler unit 24. A heater 14' is wound around the main bubbler unit 24, a carrier inlet pipe 26 and a connection pipe 29 connected to the inlet port 11. The heater 14' heats walls of these parts except the mercury reservoir 23 at about 250°C while generating the first source gas of Hg, and mercury in the reservoir 23 is cooled and maintained at room temperatures. The piston pump 27 is provided with an O-ring 28 to keep the bubbler airtight.

When the piston pump 27 moves downwardly, the liquid mercury level in the main bubbler unit 24 goes up and heated bubbled mercury generates the first source gas of Hg. When the piston pump 27 moves upwardly, the liquid mercury level in the main bubbler unit 24 goes down and all liquid mercury is received in the cooled reservoir 23 and the cooled mercury stops the generation of the first source gas. The Hg bubbler 1 of Figure 7 has a merit of eliminating a conventional valve for mecury vapor, which is made of quartz and is fragile.

The new bubbler with piston pump makes it possible to supply the first source gas Hg, which is on-off controlled alternately. A super-lattice structure of CdTe and HgTe layers can be easily obtained utilizing this type of mercury bubbler.

The above disclosures on application of the growth apparatus of the present invention have been made for growing group II-VI compound semiconductor such as ternary Hg₁₋ₓCdₓTe and quaternary Hg_{1-x-z}CdₓZn_{z}Te, but it is obvious that the invention may be applied for growing any other compound semiconductor layer such as a group III-V compound semiconductor having the similar problem.

## Claims

1. An apparatus for growing a compound semiconductor layer comprising at least three elements utilizing a plurality of source gases, said apparatus comprising:
a reactor chamber (4) of a horizontal type, the reactor chamber comprising a partition plate (9) separating the upstream region of the reactor chamber (4) into an upper region (15) and a lower region (16), the upper and lower regions (15, 16) being joined together at a region forming a growth region (17) on the downstream side of the reactor chamber(4);
a first (11) and a second inlet port (12) provided at the upstream end of said lower region (16) for admitting a first and a second source gas respectively, and a third inlet port (13) provided at the upstream end of said upper region (15) for admitting a third source gas, such that a binary semiconductor formation energy of the third source gas reacting with another one of source gases is the smallest, and an outlet port (8) provided at the downstream end of said growth region (17) for exhaust; and
a substrate stage (5) for disposing a substrate (6), whereby said substrate surface is exposed to said growth region (17) and forming a smooth surface for allowing a laminar gas flow.

2. An apparatus for growing a compound semiconductor layer as recited in claim 1, said apparatus further comprising a preliminary heating unit (33) arranged in said reactor chamber (4), said preliminary heating unit (33) being located near said substrate (5) and on the upstream side of said substrate, and a substantial surface portion of the preliminary heating unit (33) being exposed to said lower region (16) forming a smooth surface for gas flow.

3. An apparatus for growing a compound semiconductor layer as recited in claim 1, said apparatus further comprising means (14) for heating said reactor chamber arranged outside the chamber.

4. An apparatus for growing a compound semiconductor layer as recited in claim 1, said reactor chamber (4) further comprising a supplementary region (30) separated by a auxiliary partition plate (31) from said lower region (16) and growth region (17), the supplementary region (30) furnishing a space for arranging said substrate stage (5), said preliminary heating unit (33), and support members (35), and the auxiliary partition plate (31) being provided with openings for exposing the substrate surface and the preliminary heating unit (33) to the gas flow.

5. An apparatus for growing a compound semiconductor layer as recited in claim 1, said reactor chamber (4) further comprising a second partition plate (18) arranged in parallel with and below said partition plate (9), the second partition plate (18) having a length shorter than the length of said partition plate (9) and extending from the upstream end toward said growth region (17), a first lower region (16a) and a second lower region (16b) being formed in said lower region (16), the first lower region (16a) provided with said first and second inlet ports (11, 12), and a fourth inlet port (19) provided at the upstream end of the second lower region (16b) for admitting a fourth source gas to flow into the second lower region (16b), such that a binary semiconductor formation energy of the fourth source gas reacting with another one of source gases is the next smallest.

6. An apparatus for growing a compound semiconductor layer as recited in claim 1, wherein said first inlet port (11) is provided at the bottom portion of said lower region (16) and said second and third inlet ports (12, 13) are provided at the side portion of said reactor chamber corresponding to said lower and upper regions (16, 15) respectively.

7. An apparatus for growing a compound semiconductor layer as recited in claim 5, wherein said fourth inlet port (19) is provided at the side portion of said reactor chamber corresponding to said second lower region (16b).

8. An apparatus for growing a compound semiconductor layer as recited in claim 1, wherein said compound semiconductor layer is of a II-VI group ternary compound semiconductor, and said first and third source gases respectively comprise a different element selected among group II elements, and said second source gas comprises a group VI element.

9. An apparatus for growing a compound semiconductor layer as recited in claim 1, wherein said compound semiconductor layer is of a II-VI group quaternary compound semiconductor, and said first, third and fourth source gases respectively comprise a different element selected among group II elements, and said second source gas comprises a group VI element.

10. An apparatus for growing a compound semiconductor layer as recited in claim 8, wherein said ternary compound semiconductor layer is of Hg₁₋ₓCdₓTe, and said first, second and third source gases comprise respectively mercury, diisopropyltellurium and dimethylcadmium.

11. An apparatus for growing a compound semiconductor layer as recited in claim 9, wherein said quaternary compound semiconductor layer is of Hg_{1-x-z}CdₓZn_{z}Te, and said first, second, third and fourth source gases comprise respectively mercury, diisopropyltellurium, dimethylcadmium and diethylzinc.

12. An apparatus for growing a compound semiconductor layer as recited in claims 1 or 5, wherein a plurality of nozzles are provided with each of said inlet ports (11, 12, 13, 19), and source gas flow through each nozzle can be controlled individually.

13. An apparatus for growing a compound semiconductor layer as recited in claims 10 or 11, wherein said first source gas of mercury is supplied from a mercury bubbler (1), the mercury bubbler comprising:
a main bubbler unit (24);
a heater (14′) for heating the main bubbler unit (24) at a predetermined temperature;
a mercury reservoir (23) connected to the main bubbler unit (24) by a connection pipe (25); and
a piston pump (27) attached to the mercury reservoir (23), a mercury level in the main bubbler unit (24) being controlled by the movement of the piston pump.

14. A method of growing a ternary compound semiconductor layer utilizing a first, a second and a third source gas, each source gas comprising a first to a third element respectively constituting the ternary compound semiconductor, whereby the binary semiconductor formation energy of the third source gas reacting with the second source gas is smaller than that of the first source gas reacting with the second source gas, said method comprising the steps of:
providing a reactor chamber (4) of a horizontal type, the reactor chamber comprising a partition plate (9) separating the upstream region of the reactor chamber (4) into an upper region (15) and a lower region (16), the upper and lower regions (15, 16) being joined together at a region forming forming a growth region (17) on the downstream side of the reactor chamber (4), the lower region having a first (11) and a second inlet port (12) provided at the upstream end of said lower region (16) and the upper region having a third inlet port (13) at the upstream end of said upper region (15);
mixing said first and second source gases and flowing the mixed gas towards the growth region, the mixed gas being heated at a predetermined temperature before arriving the growth region;
flowing said third source gas and mixing with said previously mixed first and second source gases in the growth region where a substrate is disposed; and
heating said substrate at a predetermined temperature.

15. A method of growing a ternary compound semiconductor layer as recited in claim 14, wherein said ternary compound semiconductor layer is of Hg₁₋ₓCdₓTe, and said first, second and third source gases comprise respectively mercury, diisopropyltellurium and dimethylcadmium.

## Patentansprüche

1. Vorrichtung zum Wachsenlassen einer Verbindungshalbleiterschicht aus mindestens drei Elementen unter Verwendung einer Mehrzahl von Quellengasen, umfassend:
eine Reaktorkammer (4) vom Horizontaltyp, umfassend eine Unterteilungsplatte (9), die die stromaufwärtige Zone der Reaktorkammer (4) in eine obere Zone (15) und eine untere Zone (16) unterteilt, wobei die obere und die untere Zone (15, 16) in einer Zone verbunden sind, die eine Wachstumszone (17) auf der stromabwärtigen Seite der Reaktorkammer (4) bildet;
ein erstes (11) und ein zweites Einlaßport (12) am stromaufwärtigen Ende der unteren Zone (16) zum Einlassen eines ersten bzw. eines zweiten Quellengases, und ein drittes Einlaßport (13) am stromaufwärtigen Ende der oberen Zone (15) zum Einlassen eines dritten Quellengases derart, daß eine Zweistoffhalbleiter-Bildungsenergie des mit einem anderen der Quellengase reagierenden dritten Quellengases die kleinste ist, und ein Auslaßport (8) am stromabwärtigen Ende der Wachstumszone (17) zum Ausleiten; und
einen Substratträger (5) zur Aufnahme eines Substrats (6), wodurch die Substratoberfläche der Wachstumszone (17) ausgesetzt ist und eine glatte Oberfläche zur Ermöglichung einer laminaren Gasströmung bildet.

2. Vorrichtung zum Wachsenlassen einer Verbindungshalbleiterschicht nach Anspruch 1, gekennzeichnet durch eine in der Reaktorkammer (4) angeordnete Vorheizeinheit (33), die sich in der Nähe des Substrats (5) und auf der stromaufwärtigen Seite des Substrats befindet, wobei ein wesentlicher Oberflächenabschnitt der Vorheizeinheit (33) zu der unteren Zone (16) hin freiliegt, um eine glatte Oberfläche für die Gasströmung zu bilden.

3. Vorrichtung zum Wachsenlassen einer Verbindungshalbleiterschicht nach Anspruch 1, gekennzeichnet durch eine außerhalb der Kammer angeordnete Einrichtung (14) zum Heizen der Reaktorkammer.

4. Vorrichtung zum Wachsenlassen einer Verbindungshalbleiterschicht nach Anspruch 1, bei der die Reaktorkammer (4) weiterhin eine durch eine Hilfsunterteilungsplatte (31) von der unteren Zone (16) und der Wachstumszone (17) getrennte Zusatzzone (30), die einen Raum bildet zur Anordnung des Substratträgers (5), der Vorheizeinheit (39) und von Abstützelementen (35), und die Hilfsunterteilungsplatte (31) mit Öffnungen versehen ist, um die Substratoberfläche und die Vorheizeinheit (33) dem Gasstrom auszusetzen.

5. Vorrichtung zum Wachsenlassen einer Verbindungshalbleiterschicht nach Anspruch 1, bei der die Reaktorkammer (4) zusätzlich aufweist:
Eine zweite Unterteilungsplatte (18), die parallel zu und unterhalb der Unterteilungsplatte (9) angeordnet ist, wobei die zweite Unterteilungsplatte (18) eine geringere Länge aufweist als die Unterteilungsplatte (9), und sich von dem stromaufwärtigen Ende in Richtung auf die Wachstumszone (17) erstreckt, in der unteren Zone (16) eine erste untere Zone (16a) und eine zweite untere Zone (16b) gebildet sind, die erste untere Zone (16a) mit dem ersten und dem zweiten Einlaßport (11, 12) ausgestattet sind, und am stromaufwärtigen Ende der zweiten unteren Zone (16b) ein viertes Einlaßport (19) vorgesehen ist, damit ein viertes Quellengas in die zweite untere Zone (16b) strömen kann, so daß eine Zweistoffhalbleiter-Bildungsenergie des mit einem weiteren der Quellengase reagierenden vierten Quellengases die nächst-Kleinste ist.

6. Vorrichtung zum Wachsenlassen einer Verbindungshalbleiterschicht nach Anspruch 1, bei der das erste Einlaßport (11) an dem Bodenabschnitt der unteren Zone (16) vorgesehen ist, während das zweite und das dritte Einlaßport (12, 13) an dem Seitenabschnitt der Reaktorkammer vorgesehen sind, welcher der unteren bzw. der oberen Zone (16, 15) entspricht.

7. Vorrichtung zum Wachsenlassen einer Verbindungshalbleiterschicht nach Anspruch 5, bei der das vierte Einlaßport (19) an demjenigen Seitenabschnitt der Reaktorkammer vorgesehen ist, der der zweiten unteren Zone (16b) entspricht.

8. Vorrichtung zum Wachsenlassen einer Verbindungshalbleiterschicht nach Anspruch 1, bei der die Verbindungshalbleiterschicht aus einem II-VI-Dreistoffverbindungshalbleiter besteht, und das erste und das dritte Quellengas jeweils ein unterschiedliches Element von den Elementen der Gruppe II aufweisen, während das zweite Quellengas ein Element der Gruppe VI aufweist.

9. Vorrichtung zum Wachsenlassen einer Verbindungshalbleiterschicht nach Anspruch 1, bei der die Verbindungshalbleiterschicht aus einem II-VI-Vierstoffverbindungshalbleiter besteht, wobei das erste, das dritte und das vierte Quellengas jeweils ein anderes Element von den Elementen der Gruppe II aufweisen, während das zweite Quellengas ein Element der Gruppe VI aufweist.

10. Vorrichtung zum Wachsenlassen einer Verbindungshalbleiterschicht nach Anspruch 8, bei der die Dreistoffverbindungshalbleiterschicht aus Hg₁₋ₓCdₓTe besteht und das erste, das zweite und das dritte Quellengas Quecksilber, Diisopropyltellur bzw. Dimethylcadmium aufweisen.

11. Vorrichtung zum Wachsenlassen einer Verbindungshalbleiterschicht nach Anspruch 1, bei der die Vierstoffverbindungshalbleiterschicht aus Hg_{1-x-z}CdₓZn_{z}Te und das erste, das zweite, das dritte und das vierte Quellengas Quecksilber, Diisopropyltellur, Dimethylcadmium bzw. Diethylzink aufweist.

12. Vorrichtung zum Wachsenlassen einer Verbindungshalbleiterschicht nach Anspruch 1 oder 5, bei der eine Mehrzahl von Düsen bei jedem der Einlaßports (11, 12, 13, 19) vorgesehen ist und durch jede Düse strömendes Quellengas individuell gesteuert werden kann.

13. Vorrichtung zum Wachsenlassen einer Verbindungshalbleiterschicht nach Anspruch 10 oder 11, bei der das erste Quellengas Quecksilber von einem Quecksilberblasenbildner (1) geliefert wird, welcher aufweist:
eine Hauptblasenbildnereinheit (24);
eine Heizvorrichtung (14') zum Heizen der Hauptblasenbildnereinheit (24) auf eine vorbestimmte Temperatur; einen Quecksilbervorrat (23), der über ein Verbindungsrohr (25) mit der Hauptblasenbildnereinheit (24) verbunden ist; und eine an dem Quecksilbervorrat (23) befestigte Kolbenpumpe (27), wobei ein Quecksilberspiegel in der Hauptblasenbildnereinheit (24) durch die Bewegung der Kolbenpumpe gesteuert wird.

14. Verfahren zum Wachsenlassen einer Dreistoffverbindungshalbleiterschicht unter Verwendung eines ersten, eines zweiten und eines dritten Quellengases, von denen jedes Quellengas ein erstes bis ein drittes Element aufweist, die den Dreistoffverbindungshalbleiter bilden, wodurch die Zweistoffhalbleiter-Bildungsenergie des mit dem zweiten Quellengas reagierenden dritten Quellengases kleiner ist als diejenige des mit dem zweiten Quellengas reagierenden ersten Quellengases, wobei das Verfahren die Schritte aufweist:
Bereitstellen einer Reaktorkammer (4) eines Horizontaltyps, welche eine die stromaufwärtige Zone der Reaktorkammer (4) in eine obere Zone (15) und eine untere Zone (16) trennende Unterteilungsplatte (9) aufweist, wobei die obere und die untere Zone (15, 16) miteinander an einer Zone verbunden sind, die eine Wachstumszone (17) auf der stromabwärtigen Seite der Reaktorkammer (4) bildet, die untere Zone ein erstes (11) und ein zweites Einlaßport (12) aufweist, die an dem stromaufwärtigen Ende der unteren Zone (16) vorgesehen sind, und die obere Zone ein drittes Einlaßport (13) an dem stromaufwärtigen Ende der oberen Zone (15) aufweist;
Mischen des ersten und des zweiten Quellengases und Strömenlassen des gemischten Gases in Richtung auf die Wachstumszone, wobei das gemischte Gas vor Ankunft an der Wachstumszone auf eine vorbestimmte Temperatur aufgeheizt wird;
Strömenlassen des dritten Quellengases und Mischen mit dem zuvor gemischten ersten und zweiten Quellengas in der Wachstumszone, wo ein Substrat angeordnet ist; und
Heizen des Substrats auf eine vorbestimmte Temperatur.

15. Verfahren zum Wachsenlassen einer Dreistoffverbindungshalbleiterschicht nach Anspruch 14, bei dem die Dreistoffverbindungshalbleiterschicht aus Hg₁₋ₓCdₓTe besteht und das erste, das zweite und das dritte Quellengas Quecksilber, Diisopropyltellur und Dimethylcadmium sind.

## Revendications

1. Appareil permettant de faire croître une couche de semiconducteur composé comprenant au moins trois éléments à l'aide de plusieurs gaz sources, ledit appareil comprenant :
une chambre de réaction (4) du type horizontal, la chambre de réaction comprenant une paroi de séparation (9) qui sépare la région amont de la chambre de réaction (4) en une région supérieure (15) et une région inférieure (16), les régions supérieure (15) et inférieure (16) étant réunies ensemble à une région formant une région de croissance (17) du côté aval de la chambre de réaction (4);
un premier orifice d'entrée (11) et un deuxième orifice d'entrée (12) ménagés à l'extrémité amont de ladite région inférieure (16) afin d'admettre respectivement un premier gaz source et un deuxième gaz source, et un troisième orifice d'entrée (13) ménagé à l'extrémité amont de ladite région supérieure (15) afin d'admettre un troisième gaz source, de sorte que l'énergie de formation du troisième gaz source réagissant avec un autre des gaz sources pour former un semiconducteur binaire soit la plus petite, ainsi qu'un orifice de sortie (8) ménagé à l'extrémité aval de ladite région de croissance (17) et servant à l'évacuation ; et
un support de substrat (5) servant à disposer un substrat (6), de manière que la surface dudit substrat soit exposée à ladite région de croissance (17) et forme une surface régulière permettant un écoulement laminaire des gaz.

2. Appareil permettant de faire croître une couche de semiconducteur composé selon la revendication 1, ledit appareil comprenant en outre une unité de chauffage préliminaire (33) disposée dans ladite chambre de réaction (4), ladite unité de chauffage préliminaire (33) étant placée près dudit substrat (5) et du été amont dudit substrat, une partie de surface importante de l'unité de chauffage préliminaire (33), qui est exposée à ladite région inférieure (16), formant une surface régulière pour l'écoulement des gaz.

3. Appareil permettant de faire croître une couche de semiconducteur composé selon la revendication 1, ledit appareil comprenant en outre un moyen (14) servant à chauffer ladite chambre de réaction, qui est placé à l'extérieur de la chambre.

4. Appareil permettant de faire croître une couche de semiconducteur composé selon la revendication 1, ladite chambre de réaction (4) comprenant en outre une région supplémentaire (30) qui est séparée, par une plaque de séparation auxiliaire (31), de ladite région inférieure (16) et de ladite région de croissance (17), la région supplémentaire (30) offrant un espace qui permet la mise en place dudit support de substrat (5), de ladite unité de chauffage préliminaire (33) et d'éléments de support (35), la plaque de séparation auxiliaire (31) étant dotée d'ouvertures afin d'exposer à l'écoulement des gaz la surface du substrat et l'unité de chauffage préliminaire (33).

5. Appareil permettant de faire croître une couche de semiconducteur composé selon la revendication 1, ladite chambre de réaction (4) comprenant en outre une deuxième plaque de séparation (18) disposée parallèlement à ladite plaque de séparation (9) et au-dessous de celle-ci, la deuxième plaque de séparation (18) ayant une longueur plus courte que ladite plaque de séparation (9) et s'étendant de l'extrémité amont en direction de ladite région de croissance (17), une première région inférieure (16a) et une deuxième région inférieure (16b) étant formées dans ladite région inférieure (16), la première région inférieure (16a) étant dotée desdits premier et deuxième orifices d'entrée (11, 12), et un quatrième orifice d'entrée (19) étant ménagé à l'extrémité amont de la deuxième région inférieure (16b) afin de permettre à un quatrième gaz source de s'écouler dans la deuxième région inférieure (16b), de sorte que l'énergie de formation du quatrième gaz source réagissant avec un autre des gaz sources, pour former un semiconducteur binaire, soit d'une grandeur qui la place en deuxième position dans l'ordre croissant des énergies de formation.

6. Appareil permettant de faire croître une couche de semiconducteur composé selon la revendication 1, où ledit premier orifice d'entrée (11) est ménagé dans la partie du bas de ladite région inférieure (16), et lesdits deuxième et troisième orifices d'entrée (12, 13) sont ménagés dans la partie de côté de ladite chambre de réaction qui correspond respectivement auxdites régions inférieure (16) et supérieure (15).

7. Appareil permettant de faire croître une couche de semiconducteur composé selon la revendication 5, où ledit quatrième orifice d'entrée (19) est ménagé dans la partie de côté de ladite chambre de réaction qui correspond à ladite deuxième région inférieure (16b).

8. Appareil permettant de faire croître une couche de semiconducteur composé selon la revendication 1,où ladite couche de semiconducteur composé est faite d'un semiconducteur composé ternaire des groupes II-VI, et lesdits premier et troisième gaz sources comprennent respectivement des éléments différents choisis parmi les éléments du groupe II, tandis que ledit deuxième gaz source comprend un élément du groupe VI.

9. Appareil permettant de faire croître une couche de semiconducteur composé selon la revendication 1, où ladite couche de semiconducteur composé est faite d'un composé semiconducteur quaternaire des groupes II-VI, et lesdits premier, troisième et quatrième gaz sources comprennent respectivement des éléments différents choisis parmi les éléments du groupe II tandis que ledit deuxième gaz source comprend un élément du groupe VI.

10. Appareil permettant de faire croître une couche de semiconducteur composé selon la revendication 8, où ladite couche de semiconducteur composé ternaire est faite de Hg₁₋ₓCdₓTe, et lesdits premier, deuxième et troisième gaz sources comprennent respectivement le mercure, le diisopropyltellure et le diméthylcadmium.

11. Appareil permettant de faire croître une couche de semiconducteur composé selon la revendication 9, où ladite couche de semiconducteur composé quaternaire est faite de Hg_{1-x-z}CdₓZn_{z}Te, et lesdits premier, deuxième, troisième et quatrième gaz sources comprennent respectivement du mercure, du diisopropyltellure, du diméthylcadmium et du diéthylzinc.

12. Appareil permettant de faire croître une couche de semiconducteur composé selon la revendication 1 ou 5, où une pluralité d'ajutages sont prévus pour chacun desdits orifices d'entrée (11, 12, 13, 19), et l'écoulement de gaz source passant dans chaque ajutage peut être ajusté de façon séparée.

13. Appareil permettant de faire croître une couche de semiconducteur composé selon la revendication 10 ou 11, où ledit premier gaz source, le mercure, est fourni à partir d'un barboteur à mercure (1), le barboteur à mercure comprenant :
une unité principale de barbotage (24);
un élément chauffant (14') servant à chauffer l'unité principale de barbotage (24) à une température prédéterminée ;
un réservoir de mercure (23) raccordé à l'unité principale de barbotage (24) par un tuyau de raccordement (25); et
une pompe à piston (27) fixée au réservoir de mercure (23), le niveau de mercure dans l'unité principale de barbotage (24) étant commandé par le déplacement de la pompe à piston.

14. Procédé permettant de faire croître une couche de semiconducteur composé ternaire à l'aide d'un premier, d'un deuxième et d'un troisième gaz source, les gaz sources comprenant respectivement un premier, un deuxième et un troisième élément qui constituent le semiconducteur composé ternaire, l'énergie du troisième gaz source réagissant avec le deuxième gaz source, pour former un semiconducteur binaire, étant plus petite que l'énergie de formation du premier gaz source réagissant avec le deuxième gaz source, ledit procédé comprenant les opérations suivantes:
prévoir une chambre de réaction (4) du type horizontal, la chambre de réaction comprenant une plaque de séparation (9) qui sépare la région amont de la chambre de réaction (4) en une région supérieure (15) et une région inférieure (16), les régions supérieure (15) et inférieure (16) étant réunies ensemble à une région formant une région de croissance (17) du côté aval de la chambre de réaction (4), la région inférieure ayant un premier orifice d'entrée (11) et un deuxième orifice d'entrée (12) ménagés à l'extrémité amont de ladite région inférieure (16) et la région supérieure ayant un troisième orifice d'entrée (13) à l'extrémité amont de ladite région supérieure (15);
mélanger lesdits premier et deuxième gaz sources et faire circuler le mélange de gaz en direction d'une région de croissance, le mélange de gaz étant chauffé à une température prédéterminée avant d'arriver à la région de croissance;
faire circuler ledit troisième gaz source et le mélanger avec lesdits premier et deuxième gaz sources précédemment mélangés dans la région de croissance où un substrat est disposé ; et
chauffer ledit substrat à une température prédéterminée.

15. Procédé permettant de faire croître une couche de semiconducteur composé ternaire selon la revendication 14, où ladite couche de semiconducteur composé ternaire est faire de Hg₁₋ₓCdₓTe, et lesdits premier, deuxième et troisième gaz sources comprennent respectivement le mercure, le diisopropyltellure et le diméthylcadmium.
